# EUROPEAN PATENT APPLICATION

(11) **EP 4 817 949 A1**
(43) Date of publication of application: **07.10.2026**
(21) Application number: 25210662.0
(22) Date of filing: 23.10.2025
(51) Int. Cl.: B60L 58/16, B60L 53/10, B60L 53/62, B60L 53/66

(54) **ELECTRIFIED VEHICLE AND CHARGING CONTROL METHOD THEREOF**

(30) Priority: 01.04.2025 KR 20250042400
(71) Applicant: Hyundai Motor Company, Seoul 06797 (KR); Kia Corporation, Seoul 06797 (KR)
(72) Inventor: PARK, Sang Do, 18280 Hwaseong-si, Gyeonggi-do (KR); LEE, Sang Jin, 18280 Hwaseong-si, Gyeonggi-do (KR); KIM, Ju Seok, 18280 Hwaseong-si, Gyeonggi-do (KR); HWANG, Ji Eun, 18280 Hwaseong-si, Gyeonggi-do (KR)
(74) Representative: Viering, Jentschura & Partner mbB Patent- und Rechtsanwälte

(57) **Abstract**

Proposed are an electrified vehicle and a charging control method thereof, in which a charging mode is adjusted based on a charging environment and a state of a battery. According to an example, there is provided a charging control device including a battery, a sensor configured to measure a state of the battery, a memory configured to store usage history data of the battery, and a processor, wherein the processor is configured to determine an initial charging mode based on the usage history data, determine a degradation indicator for the state of the battery measured by the sensor as a result of accumulated charging, and determine a final charging parameter of the initial charging mode based on the degradation indicator to perform charging control of the battery.

## Description

### Technical Field

The present disclosure relates to an electrified vehicle and a charging control method thereof, in which a charging mode is adjusted based on a charging environment and a state of a battery.

### Background

The matters described in this Background section are only for enhancement of understanding of the background of the disclosure, and should not be taken as acknowledgment that they correspond to prior art already known to those skilled in the art.

When charging a battery of an electrified vehicle having an electric motor as a driving source by using external power, a charging method may depend on a supply equipment of the external power, and a charging parameter may depend on the charging method.

For example, charging methods such as rapid(fast) charging or slow charging may be determined according to a type of charging equipment or charging power, and the control of charging current according to the charging progress, such as the state of charge (SOC), may refer to a pre-determined charging map based on the charging method.

However, when charging is repeated in this way, a fixed charging map may be referenced regardless of the degree of battery degradation, and a high C-rate may be applied to achieve a fast charging speed, which may lead to rapid battery degradation.

### SUMMARY

Examples of the present disclosure are directed to providing an electrified vehicle and a charging control method thereof capable of implementing a charging strategy suitable for a charging environment and a battery state.

It will be appreciated by persons skilled in the art that technical objectives to be achieved through examples of the present disclosure are not limited to the above-mentioned technical objectives and other technical objectives which are not described herein will be clearly understood from the following description.

According to the present disclosure, an apparatus may comprise a battery, a sensor configured to measure a state of the battery, a memory configured to store usage history data of the battery, and a processor circuit configured to select, based on the usage history data, an initial charging mode of the battery, determine, based on accumulated charging of the battery and the measured state of the battery, an indicator indicating a degradation level of the battery, set, based on the indicator, a charging parameter of the initial charging mode, and control, based on the charging parameter of the initial charging mode, charging of the battery.

The processor circuit may be configured to determine, based on a battery stress level according to the indicator, whether to enable at least one of a plurality of preset charging modes, and select, as the initial charging mode, an enabled one of the plurality of preset charging modes, wherein the plurality of preset charging modes have different charging operation profiles.

The processor circuit may be configured to select the initial charging mode using a degradation impact index that represents a degree of impact of a plurality of factors, derived from the usage history data, on the degradation level of the battery.

The degradation impact index may comprise a degradation high-impact index determined based on at least one first factor having an impact greater than a threshold impact level among the plurality of factors, and a degradation low-impact index determined based on at least one second factor having an impact less than the threshold impact level among the plurality of factors.

The processor circuit may be configured to select the initial charging mode using the degradation high-impact index based on a value of the degradation high-impact index being less than a preset first threshold, or the degradation low-impact index based on a value of the degradation high-impact index being equal to or greater than the preset first threshold.

The at least one first factor may comprise at least one of a number of rapid charging events, charging power during rapid charging, or a maximum temperature of the battery when charging starts, and the at least one second factor may comprise at least one of a number of slow charging events, whether charging is performed in a preset state-of-charge (SOC) region of the battery, or a minimum temperature of the battery when charging starts.

The apparatus may further comprise an output interface, wherein the processor circuit may be configured to, based on detection of a predicted charging of the battery, output, via the output interface, information on the initial charging mode.

The processor circuit may be configured to determine whether the indicator corresponds to a normal degradation index or an abnormal degradation index, and set the battery stress level based on the determination of whether the indicator corresponds to the normal degradation index or the abnormal degradation index.

The processor circuit may be configured to determine that the indicator corresponds to the normal degradation index based on at least one of a state of health (SOH) associated with the battery, a mileage-based degradation degree determined based on preset reference information, or an internal resistance variation determined based on pulse charging of the battery, and determine that the indicator corresponds to the abnormal degradation index based on at least one of an inter-cell voltage deviation of cells of the battery, a discharge energy deviation of the battery, or a cathode potential change of the battery.

The processor circuit may be configured to determine, as the battery stress level, one of a plurality of preset levels based on the normal degradation index and the abnormal degradation index, wherein the plurality of preset levels may comprise at least one of a healthy level in which the normal degradation index and the abnormal degradation index are below respective preset thresholds, a normal degradation level in which the normal degradation index is lower than the abnormal degradation index, an abnormal degradation level in which the abnormal degradation index is lower than the normal degradation index, or a severe degradation level in which the normal degradation index and the abnormal degradation index exceed the respective preset thresholds, and adjust the charging parameter based on the normal degradation index at the normal degradation level, or the abnormal degradation index at the abnormal degradation level.

The processor circuit may be configured to set an amount of charging based on a preset condition in a charging mode among the plurality of preset charging modes, wherein the charging mode corresponds to the severe degradation level.

The processor circuit may be configured to determine the discharge energy deviation based on a ratio between a reference discharge energy and an actual discharge energy, wherein the reference discharge energy is obtained from a table predefined based on a state of charge of the battery and a temperature of the battery, and wherein the actual discharge energy is measured during driving of a vehicle using the battery.

The processor circuit may be configured to determine, based on a user-selected charging mode among the plurality of preset charging modes different from the initial charging mode, whether to enable the user-selected charging mode.

The apparatus may further comprise an output interface, wherein the processor circuit may be configured to, based on a determination to disable the user-selected charging mode, output, via the output interface, information indicating that the user-selected charging mode is inapplicable.

The processor circuit may be configured to replace, based on a determination to enable the user-selected charging mode, the initial charging mode with the user-selected charging mode, and adjust, based on the indicator, a charging parameter of the user-selected charging mode.

The processor circuit may be configured to, based on a preset charging data accumulation condition for the usage history data not being satisfied, determine the initial charging mode to be a preset mode regardless of the degradation impact index.

According to the present disclosure, an apparatus may comprise a battery, a sensor configured to measure a state of the battery, a memory configured to store usage history data of the battery, and a processor circuit configured to control charging of the battery in one charging mode among a plurality of preset charging modes, wherein the plurality of preset charging modes have different charging operation profiles, based on usage history data of the battery, determine a normal degradation index and an abnormal degradation index, wherein the normal degradation index is associated with a first battery aging rate, and wherein the abnormal degradation index is associated with a second battery aging rate greater than the first battery aging rate, based on the determined normal degradation index and the determined abnormal degradation index, adjust a charging parameter of the one charging mode, and control, based on the adjusted charging parameter of the one charging mode, charging of the battery.

The processor circuit may be configured to determine a battery stress level based on the normal degradation index and the abnormal degradation index, and based on the determined battery stress level, determine whether to enable the one charging mode for charging of the battery.

According to the present disclosure, a method may be performed by an apparatus for charging control of a battery. The method may comprise obtaining usage history information of the battery, based on the obtained usage history information, selecting an initial charging mode among a plurality of charging modes, based on the obtained usage history information, determining a normal degradation index associated with a first battery aging rate and an abnormal degradation index associated with a second battery aging rate greater than the first battery aging rate, adjusting a charging parameter of the initial charging mode based on the determined normal degradation index and the determined abnormal degradation index, and controlling, based on the adjusted charging parameter, charging of the battery.

According to the present disclosure, a vehicle may comprise a battery, a sensor configured to output sensor data associated with a state of the battery, a memory configured to store usage history data of the battery, and a processor circuit configured to select, based on the usage history data, an initial charging mode among a plurality of preset charging modes of the battery, determine, based on the sensor data and an accumulated charging of the battery, an indicator indicating a degradation level of the battery, set, based on the indicator, a charging parameter of the initial charging mode, adjust, based on the charging parameter, charging of the battery, and control, based on the adjusted charging of the battery, autonomous driving of the vehicle.

Effects that may be obtained from examples of the present disclosure will not be limited to only the above described effects. In addition, other effects which are not described herein will become apparent to those skilled in the art to which the present disclosure pertains from the following description.

### BRIEF DESCRIPTION OF THE DRAWINGS

The above and other objectives, features, and other advantages of the present disclosure will be more clearly understood from the following detailed description when taken in conjunction with the accompanying drawings, in which:
FIG. 1 shows an example of the configuration of an electrified vehicle applicable to examples;
FIG. 2 shows an exemplary concept of charging control;
FIG. 3 shows an example of a charging control process;
FIG. 4 shows an example of a charging control process;
FIG. 5 shows an example of a process for determining an initial charging mode;
FIG. 6 shows an example of a process for determining a battery stress level;
FIG. 7 shows an example of the configuration of a diagnosis charging profile;
FIG. 8 shows an example of a correlation between a battery degradation index and a charging mode;
FIG. 9 shows an example of a form in which information on an initial charging mode is output;
FIG. 10 shows an example of a form in which a user selects a charging mode;
FIG. 11 shows an example of a form in which a message indicating that a charging mode cannot be applied is output; and
FIG. 12 shows an example of a form in which charging result information is output.
FIG. 13 shows an example computing system.

### DETAILED DESCRIPTION

Particular structural or functional descriptions of examples described in the present disclosure are merely illustrative for the purpose of describing the examples, and the disclosed examples are not limited thereto but may be implemented in various forms.

Since the examples of the present disclosure may be modified in various ways and may have various forms, particular examples are shown in the drawings and will be described in detail. However, this is not intended to limit the disclosed examples to any particular form, and it should be understood that all modifications, equivalents or alternatives falling within the idea and technical scope of the present disclosure are included.

Unless otherwise defined, all terms including technical and scientific terms used herein have the same meaning as commonly understood by those skilled in the art. It will be further understood that terms used herein should be interpreted as having a meaning that is consistent with their meaning in the context of the present disclosure and the relevant art and will not be interpreted in an idealized or overly formal sense unless expressly so defined herein.

Hereinafter, the examples of the present disclosure will be described in detail with reference to the accompanying drawings. Throughout the drawings, like or similar elements are denoted by the same reference numerals, and a redundant description thereof will be omitted.

In the following descriptions of the examples, the term "preset" means that the value of a parameter is predetermined when the parameter is used in a process or algorithm. The value of the parameter may be set at the beginning of the process or algorithm, or during the execution period of the process or algorithm, according to an example.

The terms "module" and "part" for elements used herein are assigned or used interchangeably for ease of description only and are not intended to have distinct meanings or roles by themselves.

In describing an example disclosed herein, if it is determined that a detailed description of the known art related to the present disclosure makes the subject matter of the example disclosed herein unclear, the detailed description will be omitted. In addition, the accompanying drawings are only for easy understanding of the example disclosed herein, and do not limit the technical idea of the present disclosure. In addition, it is to be understood that the present disclosure includes all modifications, equivalents, and substitutions included in the spirit and the scope of the present disclosure.

The terms "first", "second", etc. used herein can be used to describe various elements, but the elements are not to be construed as being limited to the terms. The terms are only used to differentiate one element from other elements.

It will be understood that when an element is referred to as being "coupled" or "connected" to another element, it can be directly coupled or connected to the other element or intervening elements may be present therebetween. In contrast, it will be understood that when an element is referred to as being "directly coupled" or "directly connected" to another element, there are no intervening elements present.

As used herein, the singular forms "a", "an", and "the" are intended to include the plural forms as well, unless the context clearly indicates otherwise.

In the present disclosure, it is to be understood that terms such as "including", "having", etc. are intended to indicate the existence of the features, numbers, steps, actions, elements, parts, or combinations thereof disclosed herein, and are not intended to preclude the possibility that one or more other features, numbers, steps, actions, elements, parts, or combinations thereof may exist or may be added.

In addition, a unit or control unit included in names such as a motor control unit (MCU) and a hybrid control unit (HCU) is only a term that is widely used to name a control device (controller) that controls vehicle-specific functions, and does not mean a generic function unit.

A controller may include: a communication device for communicating with other controllers or a sensor so as to control a function in charge; a memory storing operating system or logic instructions and input/output information; and at least one processor performing determination, operation, and decision required for controlling a function in charge.

Examples of the present disclosure propose that an optimal charging strategy is implemented in an electrified vehicle by comprehensively considering an external factor and an internal factor in battery charging. To this end, a charging control device of an electrified vehicle may include: a data collection means for collecting usage (particularly, charging) history data of a battery; a strategy setting means for setting a charging mode based on the collected data, an external factor, and an internal factor; and a charging control means for controlling a charging process according to a charging mode determined by the strategy setting means or a charging mode determined by a user. Herein, the external factor may mean a situational or experiential factor (for example, charging experience) that intervenes between preparation and completion of charging, and the internal factor may mean a current state-related factor of the battery resulting from accumulated charging. The type of each factor and a determination method will be described later in greater detail.

The term "module" or "unit" used in the specification means a software and/or hardware component, and the "module" or "unit" performs certain operations/functions/roles. However, the "module" or "unit" is not construed as being limited to software or hardware. The "module" or "unit" may be configured to be in an addressable storage medium or to execute one or more processors. Therefore, as an example, the "module" or "unit" may include at least one of components such as software components, object-oriented software components, class components, and task components, processes, functions, attributes, procedures, sub-routines, segments of program codes, drivers, firmware, micro-codes, circuits, data, databases, data structures, tables, arrays, or variables. Functions provided in the components, "modules", or "units" may be combined into a smaller number of components, "modules", or "units" or further divided into additional components, "modules", or "units".

In the present disclosure, the "module" or "unit" may be realized as a processor and a memory. The "processor" should be widely construed to include a general-purpose processor, a central processing unit (CPU), a microprocessor, a digital signal processor (DSP), a microcontroller, a state machine, or the like. In some environments, the "processor" may refer to an application-specific integrated circuit (ASIC), a programmable logic device (PLD), or a field-programmable gate array (FPGA), and the like. For example, the "processor" may refer to a combination of processing devices such as a combination of a DSP and a microprocessor, a combination of a plurality of microprocessors, a combination of one or more microprocessors combined with a DSP core, or any other such combination. Moreover, the "memory" should be widely construed to include any electronic component capable of storing electronic information. The "memory" may refer to various types of processor-readable medium such as a random access memory (RAM), a read only memory (ROM), a non-volatile random access memory (NVRAM), a programmable read only memory (PROM), an erasable programmable read only memory (EPROM), an electrically erasable programmable read only memory (EEPROM), a flash memory, a magnetic or optical data storage device, and registers. When the processor can read information from a memory and/or record the information in the memory, the memory may be in a state of electronic communication with a processor. Memory integrated into a processor is in a state of electronic communication with the processor.

The one or more features described herein may be provided as a computer program stored in a computer-readable recording medium in order to be executed on a computer. The medium may either continuously store a computer-executable program or temporarily store the program for execution or download. Furthermore, the medium may be a variety of recording or storage means in the form of a single hardware device or multiple combined hardware devices, and is not limited to media directly connected to some computer system but may also be distributed across a network. Examples of such media include magnetic media such as a hard disk, a floppy disk, or a magnetic tape, optical recording media such as a CD-ROM or a DVD, magnetooptical media such as a floptical disk, and a ROM, RAM, or flash memory, among others, configured to store program instructions. Additional examples of such media include media or storage media that are managed by an app store that distributes applications or by various other sites or servers that provide or distribute software.

In a hardware implementation, processing units used for performing the techniques may be implemented within one or more ASICs, DSPs, digital signal processing devices, programmable logic devices, field-programmable gate arrays, processors, controllers, microcontrollers, microprocessors, electronic devices, or computers or combinations thereof designed to perform the functions described in the present disclosure.

An automation level of an autonomous driving vehicle may be classified as follows, according to the American Society of Automotive Engineers (SAE). At autonomous driving level 0, the SAE classification standard may correspond to "no automation, " in which an autonomous driving system is temporarily involved in emergency situations (e.g., automatic emergency braking) and/or provides warnings only (e.g., blind spot warning, lane departure warning, etc.), and a driver is expected to operate the vehicle. At autonomous driving level 1, the SAE classification standard may correspond to "driver assistance," in which the system performs some driving functions (e.g., steering, acceleration, brake, lane centering, adaptive cruise control, etc.) while the driver operates the vehicle in a normal operation section, and the driver is expected to determine an operation state and/or timing of the system, perform other driving functions, and cope with (e.g., resolve) emergency situations. At autonomous driving level 2, the SAE classification standard may correspond to "partial automation," in which the system performs steering, acceleration, and/or braking under the supervision of the driver, and the driver is expected to determine an operation state and/or timing of the system, perform other driving functions, and cope with (e.g., resolve) emergency situations. At autonomous driving level 3, the SAE classification standard may correspond to "conditional automation," in which the system drives the vehicle (e.g., performs driving functions such as steering, acceleration, and/or braking) under limited conditions but transfer driving control to the driver when the required conditions are not met, and the driver is expected to determine an operation state and/or timing of the system, and take over control in emergency situations but do not otherwise operate the vehicle (e.g., steer, accelerate, and/or brake). At autonomous driving level 4, the SAE classification standard may correspond to "high automation," in which the system performs all driving functions, and the driver is expected to take control of the vehicle only in emergency situations. At autonomous driving level 5, the SAE classification standard may correspond to "full automation," in which the system performs full driving functions without any aid from the driver including in emergency situations, and the driver is not expected to perform any driving functions other than determining the operating state of the system. Although the present disclosure may apply the SAE classification standard for autonomous driving classification, other classification methods and/or algorithms may be used in one or more configurations described herein.

One or more features associated with autonomous driving control may be activated based on configured autonomous driving control setting(s) (e.g., based on at least one of: an autonomous driving classification, a selection of an autonomous driving level for a vehicle, a driver preference setting, or a regulatory compliance requirement, etc.). Based on one or more features (e.g., feature of adaptive battery charging control based on degradation-aware stress evaluation) described herein, an operation of the vehicle may be controlled. The vehicle control may include various operational controls associated with the vehicle (e.g., autonomous driving control, sensor control, braking control, braking time control, acceleration control, acceleration change rate control, alarm timing control, forward collision warning time control, etc.). The vehicle control may include various operational controls associated with the battery condition (e.g., limiting acceleration when the battery stress level is high, restricting regenerative braking intensity when abnormal degradation is detected, adjusting charging power based on predicted battery aging, modifying acceleration change rate to prevent rapid current draw, restricting high-speed driving when degradation thresholds are exceeded, or delaying charging until the battery temperature stabilizes, etc.).

One or more auxiliary devices (e.g., engine brake, exhaust brake, hydraulic retarder, electric retarder, regenerative brake, etc.) may also be controlled, for example, based on one or more features (e.g., feature of adaptive battery charging control based on degradation-aware stress evaluation) described herein. For instance, auxiliary device operation may be adjusted in response to battery condition (e.g., restricting regenerative braking intensity when the battery stress level is high, enabling hydraulic or electric retarders instead of regenerative braking during abnormal degradation states, reducing exhaust brake usage to minimize high-current charging spikes, or allocating braking force distribution dynamically to protect the battery from excessive charge loads, etc.)

One or more communication devices (e.g., a modem, a network adapter, a radio transceiver, an antenna, etc., that is capable of communicating via one or more wired or wireless communication protocols, such as Ethernet, Wi-Fi, near-field communication (NFC), Bluetooth, Long-Term Evolution (LTE), 5G New Radio (NR), vehicle-to-everything (V2X), etc.) may also be controlled, for example, based on one or more features (e.g., feature of adaptive battery charging control based on degradation-aware stress evaluation) described herein. For instance, communication device operation may be adjusted in response to battery condition (e.g., restricting use of high-power radios such as 5G NR during high battery stress, scheduling non-critical data transmissions when battery stress is low, temporarily prioritizing low-power protocols such as NFC or Bluetooth under severe degradation conditions, or dynamically managing antenna usage to balance connectivity and battery health, etc.).

Minimum risk maneuver (MRM) operation(s) may also be controlled, for example, based on one or more features (e.g., feature of adaptive battery charging control based on degradation-aware stress evaluation) described herein. A minimal risk maneuvering operation (e.g., a minimal risk maneuver, a minimum risk maneuver) may be a maneuvering operation of a vehicle to minimize (e.g., reduce) a risk of collision with surrounding vehicles in order to reach a lowered (e.g., minimum) risk state. A minimal risk maneuver may be an operation that may be activated during autonomous driving of the vehicle when a driver is unable to respond to a request to intervene. During the minimal risk maneuver, one or more processors of the vehicle may control a driving operation of the vehicle for a set period of time. For instance, MRM behavior may be adjusted based on battery stress level (e.g., reducing acceleration capability when battery stress is high, limiting regenerative braking to avoid excessive charge loads, engaging auxiliary braking devices when abnormal degradation is detected, shortening the maneuver time window to prevent unsafe operation under critical battery health, or disabling autonomous driving altogether when the battery health is in serious trouble, etc.).

Biased driving operation (s) may also be controlled, for example, based on one or more features (e.g., feature of adaptive battery charging control based on degradation-aware stress evaluation) described herein. A driving control apparatus may perform a biased driving control. To perform a biased driving, the driving control apparatus may control the vehicle to drive in a lane by maintaining a lateral distance between the position of the center of the vehicle and the center of the lane. For example, the driving control apparatus may control the vehicle to stay in the lane but not in the center of the lane. The driving control apparatus may identify or determine a biased target lateral distance for biased driving control. For example, a biased target lateral distance may comprise an intentionally adjusted lateral distance that a vehicle may aim to maintain from a reference point, such as the center of a lane or another vehicle, during maneuvers such as lane changes. This adjustment may be made to improve the vehicle's stability, safety, and/or performance under varying driving conditions, etc. For example, during a lane change, the driving control system may bias the lateral distance to keep a safer gap from adjacent vehicles, considering factors such as the vehicle's speed, road conditions, and/or the presence of obstacles, etc.

For example, biased driving control may also be influenced by battery health: for instance, when the battery stress level is high, the vehicle may maintain a biased lateral position closer to a highway exit or service lane to enable safer pull-over; when abnormal degradation is detected, the system may bias driving toward the slower traffic lane to reduce load demand; when regenerative braking is restricted due to critical stress, biased driving may favor positioning with increased clearance from heavy traffic; and when battery health is in serious trouble, the vehicle may intentionally bias toward a shoulder or emergency stopping zone to prepare for a safe stop, etc.

One or more sensors (e.g., IMU sensors, camera, LIDAR, RADAR, blind spot monitoring sensor, line departure warning sensor, parking sensor, light sensor, rain sensor, traction control sensor, anti-lock braking system sensor, tire pressure monitoring sensor, seatbelt sensor, airbag sensor, fuel sensor, emission sensor, throttle position sensor, inverter, converter, motor controller, power distribution unit, high-voltage wiring and connectors, auxiliary power modules, charging interface, etc.) may also be controlled, for example, based on one or more features (e.g., feature of adaptive battery charging control based on degradation-aware stress evaluation) described herein. An operation control for autonomous driving of the vehicle may include various driving control of the vehicle by the vehicle control device (e.g., acceleration, deceleration, steering control, gear shifting control, braking system control, traction control, stability control, cruise control, lane keeping assist control, collision avoidance system control, emergency brake assistance control, traffic sign recognition control, adaptive headlight control, etc.).

For instance, when battery stress is high, energy-intensive sensors such as LIDAR or RADAR may be duty-cycled or their refresh rates reduced; when abnormal degradation is detected, the system may bias to rely more on low-power sensors (e.g., cameras or IMU) to conserve energy; when regenerative braking is restricted, traction control sensors may be adjusted to reduce torque fluctuations; and in a severe battery health state, certain auxiliary sensors (e.g., parking sensors or adaptive headlight modules) may be selectively disabled to prioritize critical sensing for safe autonomous driving (e.g., obstacle detection, collision avoidance, or lane keeping, etc.).

An autonomous driving level and/or autonomous driving activation/deactivation may also be controlled, for example, based on one or more features of adaptive battery charging control using degradation-aware stress evaluation described herein. A driving control apparatus may perform an autonomous driving level control (e.g., a change of an autonomous driving level, a change of a required user attentiveness, etc.) or cause deactivation of an autonomous driving operation. For example, when the battery stress level determined from degradation-aware indices indicates excessive degradation or accelerated aging, the driver may be required to place his/her hands on the driving wheel more often (e.g., at least once in a threshold time period, such as five seconds, 30 seconds, 1 minute, etc.). Likewise, if the stress level suggests reduced charging safety or reduced available energy, the driver may be required to look ahead more frequently (e.g., at least once in a threshold time period, such as five seconds, 30 seconds, 1 minute, etc.). Furthermore, when the degradation-aware stress evaluation exceeds a critical threshold, autonomous driving may be deactivated and a minimal risk maneuver may be initiated (e.g., controlled deceleration, lane-keeping to a shoulder, or a safe stop, etc.), while issuing a warning indicating battery-related stress that impacts driving stability.

According to the present disclosure, an electrical vehicle may implement a charging control technique in which a charging mode is selected and adjusted based on both a charging environment and a state of a battery. In particular, usage history data of the battery, such as the number of rapid charging events, charging power, and charging temperature, may be considered together with real-time sensor data indicating battery health and degradation. Based on these factors, a processor circuit may determine an initial charging mode among a plurality of preset charging modes, including, for example, a maximum power mode, a degradation mitigation mode, a care mode, and a safety mode. The processor circuit may further adjust a final charging parameter of the selected mode in response to a normal degradation index and/or an abnormal degradation index that reflect the actual stress level of the battery. By dynamically controlling charging parameters in this manner, charging efficiency may be enhanced while mitigating excessive battery wear, thereby extending battery lifespan and maintaining residual value.

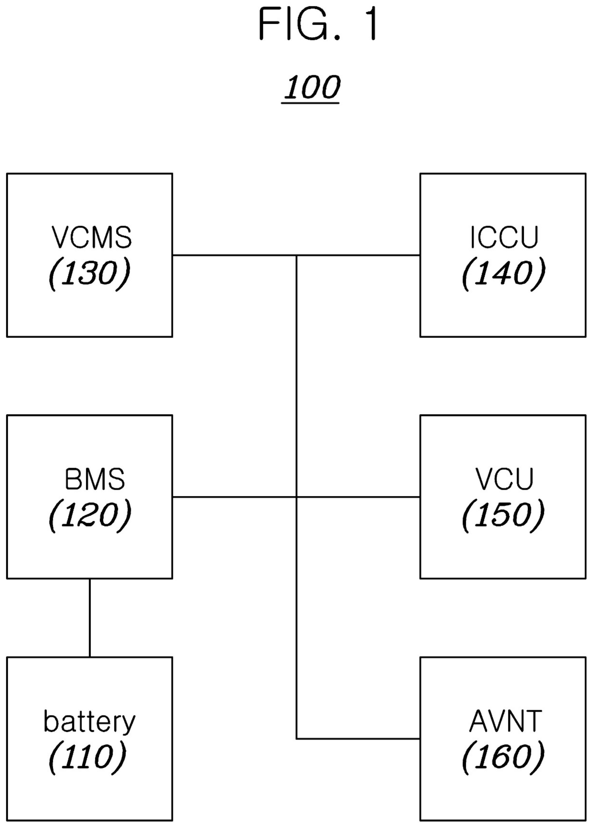

First, an electrified vehicle applicable to an example will be described with reference to FIG. 1. FIG. 1 shows an example of the configuration of an electrified vehicle applicable to examples.

Referring to FIG. 1, an electrified vehicle applicable to an example may include a battery 110, a battery management system (BMS) 120, a vehicle charging management system (VCMS) 130, an integrated charging control unit (ICCU) 140, a vehicle control unit (VCU) 150, and an audio/video/navigation/telematics (AVNT) terminal 160 (e.g., a head unit, an infotainment system, a smartphone-linked interface, or a telematics service platform, etc.).

FIG. 1 mainly shows elements related to the example. The actual implementation of the electrified vehicle may include fewer or more elements. For example, it will be apparent to those skilled in the art that the implementation of the electrified vehicle may further include a drive motor, an inverter electrically connected to the drive motor, and a motor control unit (MCU) for controlling the inverter (e.g., a three-phase AC motor, a permanent magnet synchronous motor, an induction motor, or a switched reluctance motor, etc.). Hereinafter, each element will be described in more detail.

The battery 110 is a high-capacity energy storage device capable of repeated charging and discharging, and generally refers to a lithium-ion-based secondary battery, but is not necessarily limited thereto (e.g., lithium iron phosphate (LFP), nickel-manganese-cobalt (NMC), nickel-cobalt-aluminum (NCA), or solid-state batteries, etc.

The battery management system 120 may control the battery, considering charging/discharging efficiency and lifespan. For example, the battery management system 120 may obtain and manage charging/discharging-related information and state information of the battery (e.g., state of charge (SOC), state of health (SOH), battery temperature, or internal resistance, etc.). In particular, in connection with examples of the present disclosure, the battery management system 120 may perform functions such as obtaining, preprocessing, and analyzing information on an external factor and an internal factor associated with charging, and determining a recommended mode (e.g., normal charging, fast charging, trickle charging, or safety charging mode, etc.).

The vehicle charging management system 130 may perform functions such as communication with a charging station supplying external power according to a charging protocol, such as CHAdeMO, CCS, or GB/T, etc., when charging the battery through the external power, charging speed control including adjustment of power flow, and control of start/stop of charging.

The integrated charging control unit 140 may correspond to a device in which an on-board charger (OBC) and a low-voltage DC-DC converter (LDC) are integrated to perform both charging and power conversion functions. When the on-board charger is of a bidirectional OBC type, a vehicle-to-load (V2L) function may be provided (e.g., supplying power to home appliances, camping equipment, or emergency backup systems, etc.). In particular, during charging of the battery 110, the integrated charging control unit 140 may operate under the control of the vehicle charging management system 130.

In general, when the external power is AC power, the integrated charging control unit 140 may convert the external power into DC power and charge the battery 110. Even when the external power is DC power, the integrated charging control unit 140 may perform a power conversion function to provide some sensor data to the vehicle charging management system 130 during charging or to supply power to electrical components in the vehicle (e.g., lighting, infotainment, or climate control systems, etc.) during charging.

The vehicle control unit 150 may function as a high-level controller of other controllers or control devices and may be involved in overall functional control of the electrified vehicle, including power control. For example, the vehicle control unit 150 may determine a driver's requested torque based on a sensed value of a pedal position sensor (not shown), and may transmit a torque command to a driving system controller (for example, the MCU) in consideration of both the requested torque and the state of a driving system so as to control a driving source to output torque corresponding to the torque command (e.g., engine torque, motor torque, regenerative braking torque, or combined hybrid torque, etc.).

The AVNT terminal 160 may provide route guidance and multimedia content output functions as well as a wired/wireless communication function with external entities e.g., cloud servers, smartphones, charging stations, or emergency services, etc.), and, in connection with examples, may provide a user inferface for outputting charging-related information and receiving a user's command.

It will be apparent to those skilled in the art that in the actual implementation of each element of the electrified vehicle described above, a function for which one controller is in charge may be implemented in a distributed manner by two or more controllers, or functions of which a plurality of controllers are charge may be implemented in an integrated manner by one controller (e.g., battery functions handled by both a BMS and VCU, or drive control handled by a single integrated powertrain controller, etc.).

For example, if the charging control device of the electrified vehicle 100 is regarded as including a data collection means for collecting the usage (particularly, charging) history data of the battery 110 (e.g., number of charging cycles, charging duration, temperature during charging, or SOC range, etc.), a strategy setting means for setting the charging mode based on the collected data, the external factor, and the internal factor, and a charging control means for controlling the charging process according to the charging mode determined by the strategy setting means or the charging mode determined by the user, the data collection means and the strategy setting means may correspond to the BMS 120 and the charging control means may correspond to the VCMS 130 and the ICCU 140. However, this is merely an example, and depending on the implementation, the charging control means may further include the VCU 150, or a plurality of controllers may implement the concept of one integrated controller (e.g., a domain controller, a centralized ECU, or a software-defined controller, etc.).

Based on the above-described vehicle configuration, the following describes the concept of optimal charging control comprehensively considering the internal factor and the external factor according to an example (e.g., external factors such as charging environment, charging station characteristics, or weather, and internal factors such as SOC, SOH, or resistance change, etc.).

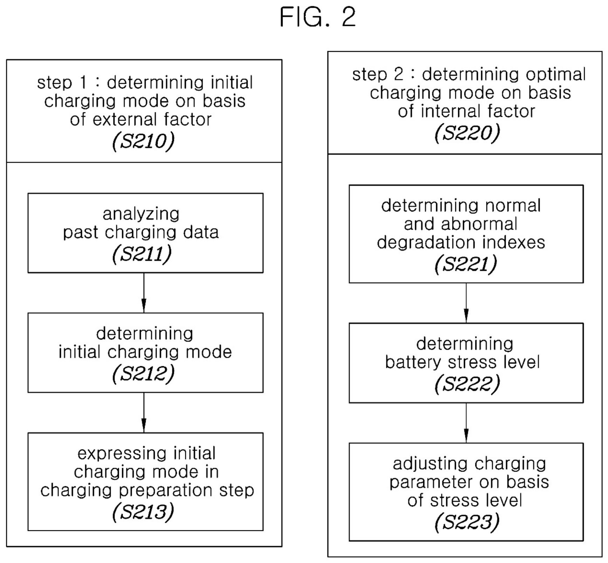

FIG. 2 shows an exemplary concept of charging control according to an example.

Referring to FIG. 2, charging control according to an example may include determining an initial charging mode based on an external factor in step S210, and determining an optimal charging mode based on an internal factor in step S220 (e.g., charging efficiency, thermal limits, battery degradation rate, or available grid power, etc.).

First, the determining of the initial charging mode based on the external factor may include analyzing past usage history (that is, charging) data in step S211, and determining the initial charging mode based on a result of analysis in step S212. The initial charging mode determined through this may be expressed in a charging preparation step in step S213 to assist the driver in determining the charging mode. When the driver does not select the charging mode manually, charging may be performed according to the initial charging mode. Herein, examples of the usage history data may include the number of rapid charging events, the number of slow charging events, charging power, the battery temperature at the start of charging, and information on whether charging is performed in a high SOC section (e.g., charging above 80% SOC, charging below 20% SOC, or charging at elevated ambient temperatures, etc.). That is, the external factor considered in determining the initial charging mode may include charging experiences that affect degradation, such as exposure to rapid charging, charging in a high temperature environment, charging in a low temperature environment, and charging to a high SOC (e.g., frequent use of ultra-fast charging stations, charging during summer/winter extremes, or repeated top-off charging to near 100%, etc.). However, this is merely an example and is not limited thereto. However, it should be noted that the external factor is intended to reflect the frequency and intensity of exposure of the battery to particular charging environments associated with degradation, and is not a factor derived by measuring or calculating the actual effect on the battery after such exposure to the charging environments or charging experiences.

Next, the determining in step S220 of the optimal charging mode based on the internal factor may include determining a degradation indicator such as a normal degradation index and an abnormal degradation index in step S221, and determining a battery stress level, considering each of the indices together in step S222. The stress level of the battery determined through this may restrict the charging mode that may be finally selected during the charging preparation process. When an unrestricted charging mode, such as the initial charging mode, is determined, the stress level may contribute to providing an optimal charging mode by finally adjusting a charging parameter (e.g., charging power, charging current, charging speed, a target SOC, charging voltage, or charging duration, etc.) of the charging mode in step S223.

Herein, the normal degradation index may correspond to a result of diagnosing a normal degradation degree, and may include a degradation degree index based on a mileage, and a degradation degree index based on an internal resistance of the battery measured during a charging process having a particular pattern (e.g., pulse charging, step charging, or constant current/constant voltage charging, etc.). In addition, the abnormal degradation index may correspond to a result of diagnosing an abnormal degradation degree, and may include an abnormal degradation degree index according to an inter-cell voltage deviation, an abnormal degradation degree index based on a measured discharge energy, and an abnormal degradation degree index based on a cathode potential (e.g., lithium plating, dendrite growth, or cathode material instability, etc.). However, these indices are merely examples, and are not limited to any particular form as long as they are factors that can be used to indicate the normal or abnormal degradation degree of the battery.

The battery stress level determined considering the degradation indexes together may include a plurality of levels, and the respective levels may correspond to different normal degradation index ranges and abnormal degradation index ranges. For example, the battery stress level may include level 1, which indicates a healthy state, level 2, which indicates a state in which normal degradation has started, level 3, which indicates a state in which abnormal degradation has started, level 4, which indicates a state in which normal degradation and abnormal degradation are mixed, and level 5, which corresponds to rapid abnormal degradation (e.g., sudden cell imbalance, sharp resistance rises, or severe energy fade, etc.). However, this is merely an example and is not limited thereto.

A method of determining each degradation index and a method of determining a battery stress level based on each determined degradation index will be described in more detail later (e.g., algorithms using lookup tables, machine learning models, regression-based estimations, or threshold-based decision logic, etc.).

In the meantime, a charging mode that may be set as the initial charging mode may include a plurality of modes. The respective modes may differ in at least one of the following elements: the utilization ratio of the maximum charging power of charging equipment supplying external power, charging speed, the state of charge (SOC) as a charging termination reference, and a method of setting a target charging amount (e.g., percentage-based termination, fixed energy amount, range-based termination, or user-defined SOC window, etc.). Accordingly, a charging operation profile, which refers to a charging form, behavior, or pattern represented by a combination of the elements, may differ between the modes (e.g., normal mode, fast charging mode, trickle charging mode, eco mode, or safety mode, etc.).

For example, a charging mode according to an example may include a maximum power charging mode, a degradation mitigation mode, a care charging mode, and a safety charging mode (e.g., eco charging mode, balanced charging mode, or user-customized charging mode, etc.).

Herein, the maximum power charging mode refers to a mode in which the battery is charged using the maximum charging power of the charging equipment supplying external power, and may achieve the fastest charging speed among the plurality of charging modes (e.g., ultra-fast DC charging at 350 kW, high-power AC charging, or maximum-rated onboard charger mode, etc.).

The degradation mitigation mode may refer to a mode in which the battery is charged with charging power lower than the maximum charging power. In the degradation mitigation mode, the charging parameter may be adjusted considering the normal degradation index or the abnormal degradation index or both (e.g., reducing charging current, lowering maximum SOC target, or modifying charging ramp profiles, etc.).

For example, if the battery stress level is level 2 corresponding to the start of normal degradation and the degradation mitigation mode is determined as the charging mode, the charging parameter may be adjusted based on the normal degradation index. The adjustment may be made in a direction that mitigates degradation as the normal degradation index decreases (e.g., the charging current for each SOC section is lowered, the charging completion SOC is lowered, or charging pauses are introduced during high-temperature operation, etc.).

As another example, if the battery stress level is level 3 corresponding to the start of abnormal degradation and the degradation mitigation mode is determined as the charging mode, the charging parameter may be adjusted based on the abnormal degradation index. Even in this case, the adjustment may be made in a direction that mitigates degradation as the abnormal degradation index decreases (e.g., the charging current for each SOC section is lowered, the charging completion SOC is lowered, or thermal management functions such as pre-cooling are triggered, etc.). However, when the adjustment is based on the abnormal degradation index, a greater adjustment in the direction of mitigating degradation may be made compared to the case in which the normal degradation index of the same value is used.

In the care mode, a lower charging speed than that in the degradation mitigation mode may be provided, and the charging current may be controlled to a level that delays the decrease in the residual value of the battery as much as possible. In addition, in selecting a charging schedule, the charging time (that is, the charging amount) may be set in units of a predetermined time interval (e.g., 10-minute intervals, 30-minute intervals, or 1-hour intervals, etc.) based on the remaining SOC, but this is merely an example and is not limited thereto.

In the meantime, the safety mode is a charging mode in which safety is prioritized until an appropriate maintenance service is received, and may restrict the charging termination SOC and may provide the lowest charging speed among the plurality of charging modes (e.g., limiting SOC to 50%, using trickle charging only, or disabling fast charging options, etc.).

The classification, names, and characteristics of the plurality of charging modes are merely examples provided to aid in understanding the examples of the present disclosure, and it will be apparent to those skilled in the art that the present disclosure is not limited thereto and that more or fewer charging modes may be applied in actual implementations (e.g., smart grid adaptive mode, renewable energy-linked charging mode, or fleet-optimized charging mode, etc.).

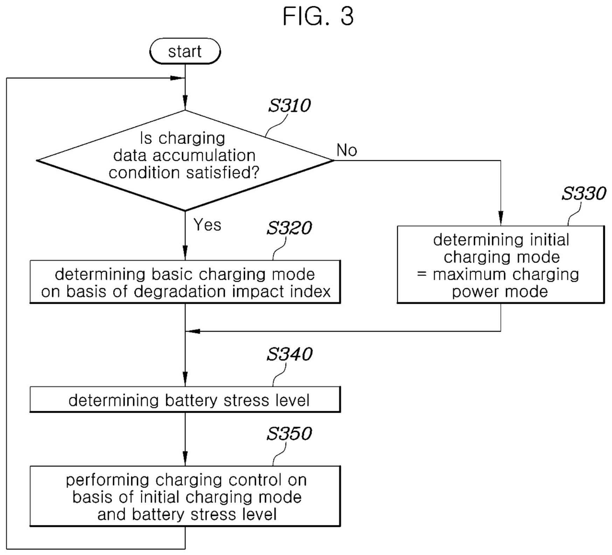

FIG. 3 shows an example of a charging control process according to an example.

Each step shown in FIG. 3 may basically be performed by the battery management system 120, but this is merely an example and is not limited thereto. For example, in step S320, the battery management system 120 may obtain information required for determination and transmit the same to a connected car service server through the communication function of the AVNT terminal 160, and the connected car service server may determine the initial charging mode and transmit the same to the battery management system 120 through the AVNT terminal 160 (e.g., via LTE, 5G, Wi-Fi, or dedicated V2X protocols, etc.). In the following description with reference to the following drawings including FIG. 3, it will be described that each step is performed by a "controller" for convenience.

Referring to FIG. 3, first, the controller may determine whether a charging data accumulation condition is satisfied in step S310. The charging data accumulation condition may refer to a condition for determining whether external factors related to charging, that is, the usage history data of the battery, have been accumulated sufficiently to determine the initial charging mode. For example, in the case of a near-new vehicle that has not yet completed the break-in period, the number of charging events is likely to be small, and the operation period is short, so it is highly unlikely that the battery has been exposed to charging environments or charging experiences that affect degradation, at or beyond a particular level (e.g., repeated high-power DC fast charging, frequent charging in sub-zero conditions, or prolonged charging to 100% SOC, etc.). Accordingly, the degree of battery degradation may be considered to be very low. In this case, the controller may determine that the charging data accumulation condition is not satisfied in step S310 (No).

For example, the charging data accumulation condition may be set to consider at least one selected from the group of the number of charging events, an operation period after leaving the factory, and a driving distance (e.g., number of rapid charging sessions, cumulative calendar age of the battery, or total kilometers driven, etc.). According to another example, the charging data accumulation condition may be simplified to mileage. More specifically, regarding the charging data accumulation condition, it may be determined that the charging data accumulation condition is satisfied when the mileage reaches 2,000 to 3,000 km, which is generally regarded as a break-in driving distance for a typical vehicle (e.g., compact sedans, mid-size SUVs, or light-duty trucks, etc.). However, this is merely an example and is not limited thereto.

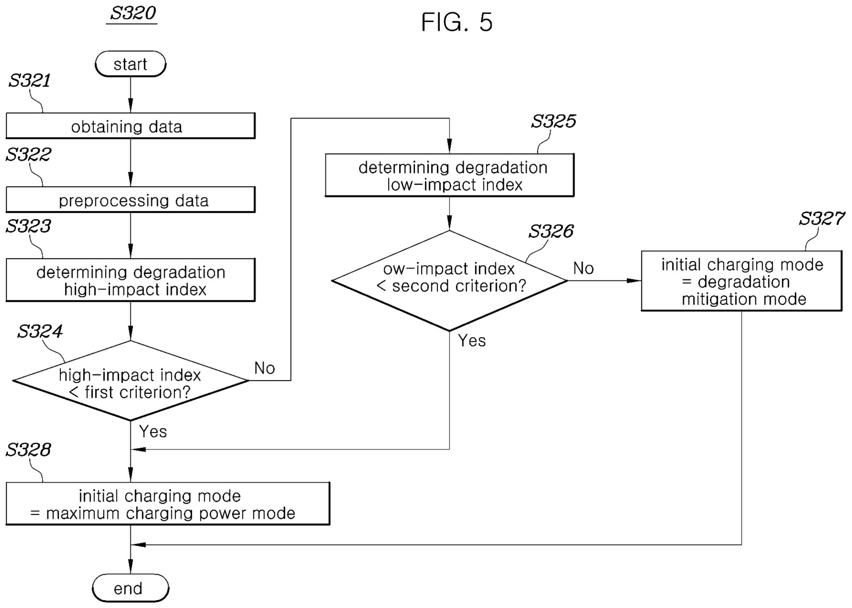

If the charging data accumulation condition is satisfied in step S310 (Yes), the controller may determine the initial charging mode in step S320. Herein, the controller may determine the initial charging mode based on a degradation impact index. As described above, the degradation impact index is obtained by quantifying the external factor that affects the battery degradation degree, and may include a high-impact index, which has a relatively high impact on the degree of degradation, and a low-impact index, which has a relatively small impact (e.g., high-impact factors such as repeated high SOC charging or charging in extreme heat, versus low-impact factors such as occasional slow charging or charging at moderate temperatures, etc.). A factor including the high-impact index and the low-impact index, a method of deriving the factor, and a method of determining an initial charging mode based on the indexes will be described in more detail later with reference to FIG. 5.

Conversely, if the charging data accumulation condition is not satisfied in step S310 (No), the controller may determine the initial charging mode to the maximum charging power mode in step S330. This is because the cumulative usage of the battery is low, the degree of degradation progress is considered to be low and there is less need to limit the charging power (e.g., new vehicles within the first 1,000 km, batteries replaced recently, or fleets with very low initial utilization, etc.).

In addition, the controller may determine the battery stress level in step S340. When both the initial charging mode and the battery stress level are determined, the controller may perform charging control, such as outputting information related to the initial charging mode in the charging preparation step, adjusting the charging parameter based on the battery stress level, and determining a final charging parameter, in step S350 (e.g., adjusting maximum charging current, reducing charging termination SOC, delaying charging start time, or enabling thermal preconditioning, etc.).

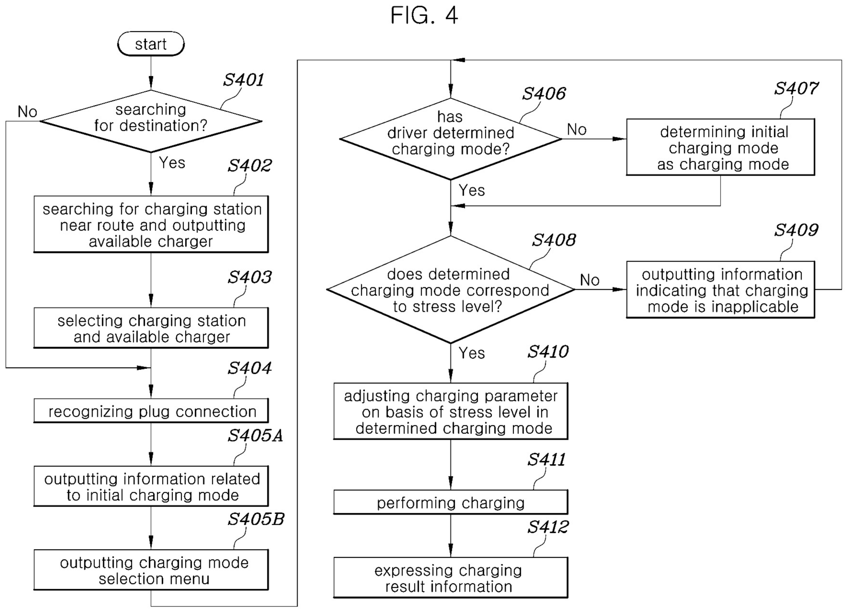

Hereinafter, a specific process of performing charging control while a basic charging parameter and a battery stress level are determined will be described with reference to FIG. 4.

FIG. 4 shows an example of a charging control process according to an example.

Referring to FIG. 4, when the driver searches for a destination through the AVNT terminal 160 in step S401 (Yes), the vehicle control unit 150 may compare the distance to empty (DTE) with the distance to the destination, and may search for a charging station near the route through the AVNT terminal 160 when charging is required, and may enable information on an available charger to be output in step S402. In this way, a function for searching for and providing a charging route when charging is required to reach a destination through cooperative control between the vehicle control unit 150 and the AVNT terminal 160 may be referred to as a route planner (e.g., displaying fast chargers along the highway, showing nearby AC chargers at shopping centers, suggesting V2H-compatible chargers, or filtering stations by payment type, etc.).

Herein, when the driver selects the charging station and the available charger, the controller may set a basic charging environment based on the pre-determined initial charging mode for the charger in step S403. Afterward, when the connection of the plug of the charger is recognized upon arrival at the selected charging station, the controller may enable the information related to the initial charging mode to be output through the AVNT terminal 160 in step S405A (e.g., displaying estimated charging time, expected cost, SOC target, or predicted battery temperature rise, etc.).

Conversely, if the driver does not specify a destination in step S401 (No) and the connection of the plug is recognized in step S404, the controller may set a basic charging environment based on charger information obtained through communication with the charger via the connected plug and the pre-determined initial charging mode, and may enable the information related to the initial charging mode to be output through the AVNT terminal 160 in step S405A (e.g., charger type, maximum supported power, charging protocol, or connector standard such as CCS or CHAdeMO, etc.).

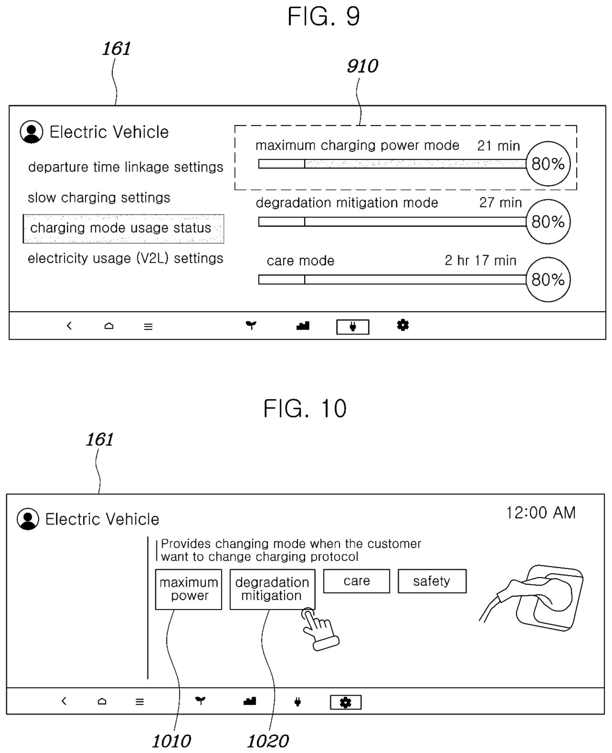

In addition, the controller may enable a charging mode selection menu for the user to select any one of the plurality of charging modes (that is, the maximum power charging mode, the degradation mitigation mode, the care charging mode, and the safety charging mode) described above, to be output through the AVNT terminal 160 in step S405B (e.g., selectable via touch screen buttons, voice commands, steering wheel controls, or mobile app interface, etc.). A specific form of the charging mode selection menu will be described with reference to FIG. 10.

Herein, setting the basic charging environment may mean that assuming that charging is performed through the charger connected to the plug in the pre-determined initial charging mode among the plurality of charging modes, preparation (e.g., determining the charging power, loading the charging profile, calculating the estimated time required for charging, or predicting expected charging cost, etc.) is performed in advance. However, even with the initial charging mode determined, the final charging mode may be determined in step S406 according to a command input of the driver through the charging mode selection menu provided in step S405B. If the driver does not select the charging mode manually in step S406 (No), the final charging mode is the initial charging mode in step S407. If the driver selects the charging mode manually in step S406 (Yes), the charging mode selected by the driver may be determined as the final charging mode. Herein, the case in which the driver does not select the charging mode manually in step S406 (No) may include inputting a "confirm" or "start charging" command by the driver without making a separate selection from the charging mode selection menu provided in step S405B as well as finally selecting the pre-determined initial charging mode (e.g., defaulting to maximum power charging if no override is made, or keeping the safety mode active if maintenance is pending, etc.).

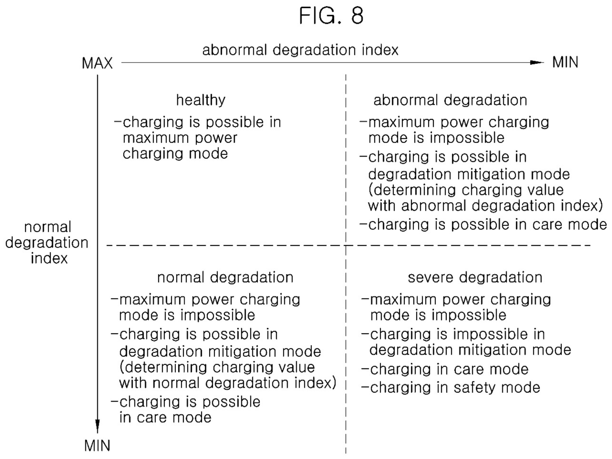

The controller may determine whether the determined charging mode corresponds to the current stress level of the battery (e.g., the most recently determined battery stress level, SOC range, or thermal condition, etc.) in step S408. For example, when the stress level is at the lowest level, all charging modes may correspond (i.e., be permitted or enabled) thereto. As the stress level increases, at least some charging modes may gradually become restricted (e.g., fast charging disabled at high stress levels, only care mode or safety mode allowed, or SOC capped at 80%, etc.). A specific relationship between the stress levels and the permission/restriction of charging modes will be described in more detail with reference to FIG. 8.

If the determined charging mode does not correspond to the battery stress level in step S408 (No), the controller may output information indicating that the selected charging mode cannot be applied to the current charging through the AVNT terminal 160 in step S409 (e.g., displaying a warning popup, providing an audible alert, suggesting an alternative mode, or highlighting stress indicators on the display, etc.).

Conversely, if the determined charging mode corresponds to the battery stress level in step S408 (Yes), the controller may determine a final charging parameter by adjusting the charging parameter based on the stress level in the determined charging mode in step S410, and may perform charging based on the adjusted parameter (that is, the final charging parameter) in step S411. Herein, the adjustment step S410 may be omitted depending on the determined charging mode (e.g., when the charging mode is the maximum charging power mode, a fixed fast-charge profile, or an emergency override charging profile, etc.).

After charging is completed, charging result information may be expressed through the AVNT terminal 160 in step S412. It is to be understood that the charging result information may be output through other in-vehicle output devices, such as a cluster, in addition to the AVNT terminal 160, or may be transmitted to an external device, such as a connected car service server, to be output through a webpage or a smartphone application (e.g., a mobile app notification, email report, in-vehicle heads-up display, or cloud-based charging history log, etc.).

In the meantime, with reference to FIG. 4, it has been described that the condition for outputting the information on the initial charging mode or the charging mode selection menu is the recognition of the connection of the charging connector, but this is merely an example, and any situation that reflects the user's intention of charging may be applicable thereto. For example, situations in which the controller may determine that the user intends to charge may include a search for a charging station, entry into a charging station, detection of an event indicating the need for charging based on a charging schedule through the connection with the user's terminal or a distance to a destination compared to the current SOC, and prediction of the charging time point through learning of the user's usage patterns (e.g., detecting low SOC warnings, receiving a scheduled charging reminder, analyzing routine commuting routes, or identifying repeated night-time charging behavior, etc.).

Hereinafter, the step S320 of determining the initial charging mode will be described in more detail with reference to FIG. 5.

FIG. 5 shows an example of a process for determining an initial charging mode according to an example.

Referring to FIG. 5, first, the controller may obtain data for determining a degradation high-impact index and a degradation low-impact index in step S321, and may perform preprocessing on the obtained data in step S322. Herein, the obtaining in step S321 of obtaining the date may refer to a step of searching a storage device, such as a memory of the BMS 120, for the accumulated past usage (charging) history data or loading the same, and the preprocessing in step S322 may refer to a step of excluding data not satisfying a preset condition among the loaded data from an analysis target. For example, with respect to the data obtained during a single charging cycle, if the required/duration time of the charging cycle is shorter than a preset criterion (e.g., less than 10 minutes, less than 5% SOC increase, or interrupted charging due to user cancellation, etc.) or if the SOC value increased through charging is less than a particular criterion (e.g., 50 %, 40%, or another SOC threshold, etc.), the data may not be considered in determining the initial charging mode.

Based on the preprocessed data, the controller may determine the degradation high-impact index in step S323. If the degradation high-impact index is lower than a preset first criterion in step S324 (Yes), the controller may set the initial charging mode to the maximum charging power mode. As described above, the degradation high-impact index is determined according to the number of exposures to situations having a greater impact on the degradation of the battery than those represented by the degradation low-impact index (e.g., repeated rapid charging, charging in very high or very low ambient temperatures, or charging to 100% SOC frequently, etc.). The degradation high-impact index lower than the first criterion may indicate that the state of the battery is very healthy. Therefore, the controller may determine the initial charging mode to the maximum charging power mode in step S328 (e.g., enabling fastest charging with no restrictions, applying standard fast-charging curves, or using factory-default OBC profiles, etc.).

For example, the degradation high-impact index may be determined based on the number of rapid charging events, charging power, and the number of exposures to a high temperature (the maximum temperature at the start of charging) (e.g., charging at 250 kW multiple times, charging at 35-45 °C ambient temperature, or charging after aggressive highway driving when battery heat is elevated, etc.). However, this is merely an example and is not limited thereto.

Conversely, if the degradation high-impact index is equal to or greater than the first criterion in step S324 (No), the controller may determine the degradation low-impact index in step S325.

For example, the degradation low-impact index may be determined based on the number of slow charging events, whether charging is performed in a high SOC region, and the number of exposures to a low temperature (the minimum temperature at the start of charging) (e.g., frequent AC charging sessions at home, repeated charging above 80% SOC, charging at or below 0 °C, or charging after overnight parking in sub-zero conditions, etc.). However, this is merely an example and is not limited thereto.

If the degradation low-impact index is less than a preset second criterion in step S326 (Yes), the controller may determine the initial charging mode to the maximum charging power mode in step S328. Conversely, if the degradation low-impact index is equal to or greater than the preset second criterion in step S326 (No), the controller may determine the initial charging mode to the degradation mitigation mode in step S327. This is intended to allow the maximum charging power mode whenever possible, considering the driver's intention of rapid charging as much as possible, while mitigating the progression of battery degradation if both the degradation high-impact index and the degradation low-impact index exceed respectively set criteria, which may be regarded as an indication that degradation is in progress (e.g., repeated exposure to high C-rate charging combined with frequent high SOC storage or charging in extreme cold, etc.).

A specific example of a method of calculating the degradation high-impact index and the degradation low-impact index is shown in Table 1 below.

**[Table 1]**

| Index | Degradation high-impact index | | Degradation low-impact index | |
|---|---|---|---|---|
| Base data (factor) | Rapid charging power (count) | Charging start temperature (count) | SOC section (count) | Charging start temperature (count) |
| Count per condition | 250 kw (4) | 35 °C or more (1) | 80 % or more (1) | 10 °C or less (1) |
| | 150 kw (3) | | | |
| | 100 kw (2) | | | 0 °C or less (2) |
| | 50 kw (1) | | | |

Referring to Table 1, the degradation high-impact index may be determined by applying different counts for each charging power during rapid charging, so that the index may be calculated considering both the number of rapid charging events and the charging power. Each time the charging start temperature exceeds a criterion, the count may be increased by 1. The counts for each factor may be cumulatively summed. For example, when charging has been performed 10 times with the charging power of 250 kw, the total count for the rapid charging power factor becomes 4*10 = 40. In addition, when the charging start temperature is 35 °C or more two times, the total count for the charging start temperature factor becomes 2*1 = 2. As a result, the degradation high-impact index may be determined to be (4*10)+(2*1)= 42 (e.g., a high index score signals aggressive charging habits or thermal stress requiring mitigation, etc.).

In determining the degradation low-impact index, different counts are applied to charging start temperature ranges, so that the charging start temperature ranges and the number of times are considered in calculating the index. If charging is in a high SOC section (that is, SOC 80 % or more), the count is increased by 1. Similar to the determination of the degradation high-impact index, the degradation low-impact index may also be determined by cumulatively summing the counts for each factor (e.g., charging at 90% SOC during cold weather multiple times, or slow charging at 7 kW repeated daily, etc.).

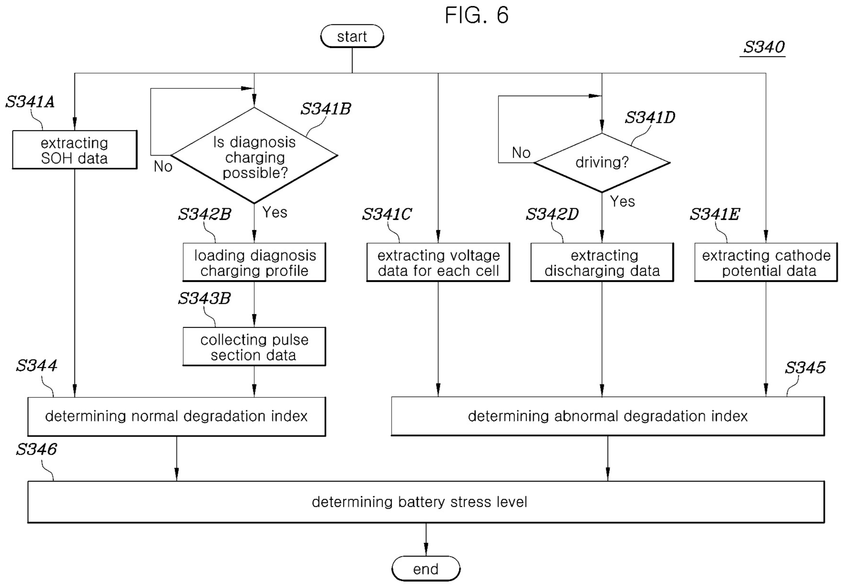

Next, a process of determining the battery stress level will be described in more detail with reference to FIG. 6.

FIG. 6 shows an example of a process for determining a battery stress level according to an example.

In FIG. 6, it is assumed that the determination of the normal degradation index considers information on a mileage-based degradation degree (SOH) and a variation in the internal resistance of the battery measured during the charging process to which a diagnosis charging profile is applied, and the determination of the abnormal degradation index considers an inter-cell voltage deviation, a discharge energy deviation according to SOC and temperature, and a cathode potential value (e.g., cathode overpotential at high current, lithium plating signals, or unusual discharge slope changes, etc.).

Referring to FIG. 6, the controller may extract SOH data for determining the driving distance-based degradation degree from a memory, for example, a memory of the BMS 120, in step S341A (e.g., cumulative mileage records, charging/discharging cycle counts, or logged SOH history data, etc.).

In addition, in order to determine the variation in the internal resistance, when diagnosis charging is possible in step S341B (Yes), the controller may load the diagnosis charging profile to the VCMS 130 in step S342B and may collect data of a particular section in step S343B. Herein, the diagnosis charging profile may refer to a charging profile in which one or more resting sections for stopping the supply of charging current or discharging sections for performing discharging at a particular C-rate are set in order to more accurately measure the internal resistance of the battery during charging (e.g., applying a rest step every 10% SOC increase, applying a 1C discharge pulse, or inserting a 5-minute zero-current rest, etc.). A particular section that serves as a data collection target in step S343B may refer to a discharging section or a resting section, and the charging current has a pulse form in the section, so this section may be referred to as a "pulse section" for convenience. In addition, the case in which diagnosis charging is possible may mean that the charging start SOC is satisfied, which allows charging to proceed through both the resting section and the discharging section set in the diagnosis charging profile. However, no limitation thereto is imposed. For example, the condition for determining that diagnosis charging is possible may additionally require that departure is not scheduled before the estimated time required for charging elapses, in addition to satisfying the charging start SOC (e.g., vehicle is parked overnight, charging session is scheduled during off-peak hours, or charging is initiated at 30-70% SOC range, etc.).

When SOH data and pulse section data are collected, the controller may determine the normal degradation index in step S344.

The controller may determine the mileage-based degradation degree based on preset reference information. Specifically, the controller may determine the mileage-based degradation degree using the ratio of the current SOH to the warranty target SOH section of the battery. For example, when the warranty target SOH is 70 %, the actual warranty target SOH section becomes the upper 30 % section between 100 % and 70 %. When the current SOH is 85 %, it falls in the middle of the 100 % to 70 % section, so the mileage-based degradation degree may be determined to be 50 %. As another example, when the current SOH is 90 %, it corresponds to 20 % of the 30 % range and the mileage-based degradation degree may thus be determined to be 67 %. In summary, the mileage-based degradation degree may be calculated using the following expression: "{(current SOH - warranty SOH)/(100 - warranty SOH)}*100". In the meantime, the current SOH may be determined according to a capacity-based SOH calculation method, such as the current battery capacity compared to the battery capacity when leaving the factory, but this is merely an example and is not limited thereto (e.g., coulomb counting methods, open circuit voltage estimation, or impedance-based SOH estimation, etc.). In addition, the warranty target SOH section does not necessarily have to be set identically to the SOH section warranted by the manufacturer for the battery (e.g., some OEMs may use 70% SOH, others may use 75% or 80% SOH, etc.).

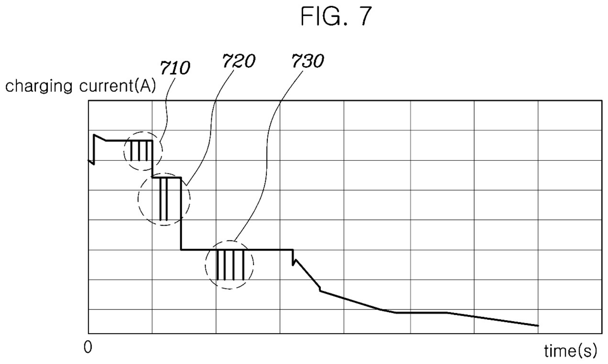

Next, the controller may determine the variation in the internal resistance of the battery by using the pulse section data. To this end, the controller may obtain the internal resistance for each section based on the voltage change in the pulse section (e.g., calculating ΔV/ΔI for each pulse, averaging resistance values across SOC bands, or trending resistance growth over time, etc.). A specific form of the pulse section will be described with reference to FIG. 7.

FIG. 7 shows an example of the configuration of a diagnosis charging profile according to an example.

Referring to FIG. 7, the diagnosis charging profile may include three constant current (CC) sections, and one or more pulse sections 710, 720, and 730 may be set for each CC section. For example, three pulse sections 710 may be set in the CC section corresponding to the section with the lowest SOC. When charging is performed based on the diagnosis charging profile, all of the pulse sections 710, 720, and 730 may be passed through within a single diagnosis charging cycle, and the voltage change for each section may be monitored. When the internal resistance is obtained for each of the plurality of pulse sections within a single diagnosis charging cycle, the internal resistance average for each section may be used as an internal resistance value of the diagnosis charging cycle (e.g., averaging values across 20-40% SOC, 40-60% SOC, and 60-80% SOC ranges, etc.).

The variation in the internal resistance of the battery may be determined by comparing the internal resistance value of this diagnosis charging cycle with the internal resistance value of the previous diagnosis charging cycle (e.g., tracking resistance growth trends over weekly, monthly, or seasonal intervals, etc.).

Referring back to FIG. 6, the controller may quantify the mileage-based SOH degradation degree and the variation in the internal resistance through comparison with preset respective criteria. For example, the mileage-based SOH degradation degree may be matched to a larger index value as the degree value increases. The variation in the internal resistance may be matched to a larger index value as the variation value decreases (e.g., mapping 5% SOH drop to index 1, 10% drop to index 2, or <1 mΩ resistance variation to index 1, >5 mΩ variation to index 3, etc.).

In the meantime, in order to determine the abnormal degradation index, the controller may extract the voltage data for each cell in step S341C, and may extract, while the vehicle is driving in step S341D (Yes), discharging data in step S342D, and may extract cathode potential data in step S341E, and may determine the abnormal degradation index based on these types of data in step S345 (e.g., by combining voltage imbalance data, discharge efficiency data, and electrode potential diagnostics, etc.).

Specifically, the controller may determine the inter-cell voltage deviation based on voltage data for each cell. Herein, the inter-cell voltage deviation may refer to a difference between the voltage of the cell with the highest voltage and the voltage of the cell with the lowest voltage, and voltage data for each cell when a preset SOC condition and a temperature condition are satisfied may be used. The SOC condition and the temperature condition may be determined within a SOC section (e.g., 50 ~ 70 %) that is neither too high nor too low and a temperature section (e.g., 20 °C ~ 30 °C) that is above room temperature but not excessively high. However, these are merely examples and are not limited thereto. The reason for considering the inter-cell voltage deviation in the determination of the abnormal degradation index is that a cell with a relatively low voltage may indicate the presence of leakage current, and there is a possibility of sparks due to a micro short between the cathode and the anode (e.g., internal dendrite growth, separator damage, or electrode misalignment, etc.).

In addition, the controller may determine the discharge energy deviation by comparing the discharging data with a preset discharge energy table for each condition. The discharge energy table for each condition defines a normal discharge energy for each temperature and SOC, and discharging data may include information on a battery state (temperature and SOC) and discharge energy when battery discharge occurs during driving. As abnormal degradation progresses in the battery, the discharge energy tends to decrease compared to that in a normal state. Therefore, abnormal degradation may be diagnosed through the discharge energy deviation. Herein, the discharge energy deviation may refer to a difference between a discharge energy table value and actual discharge energy, or may refer to a ratio of the actual discharge energy to the discharge energy table value (e.g., actual discharge energy is 85% of table value at 25 °C and 50% SOC, or actual discharge energy drops to 70% of expected value in cold conditions, etc.).

In addition, the controller may analyze cathode potential change based on the cathode potential data. More specifically, the controller may diagnose abnormal degradation of the battery based on the number of times that cathode potential falls below 0 within a pre-determined SOC section (e.g., 50 ~ 60 %) and variation. This is intended to diagnose abnormal degradation such as lithium plating or lithium dendrite formation, through the principle that lithium is deposited on the anode and anode potential decreases during repeated charging and discharging of the battery (e.g., during frequent winter fast charging, repeated deep cycling, or prolonged storage at high SOC, etc.).

The controller may quantify the inter-cell voltage deviation, the discharge energy deviation, and the cathode potential change through comparison with preset respective criteria. For example, the inter-cell voltage deviation may be matched to a larger index value as the deviation decreases. The discharge energy deviation may be matched to a lower index value as the actual discharge energy value compared to the table value decreases. The cathode potential change may be matched to a higher index value as the change decreases (e.g., inter-cell deviation <20 mV = index 1, 21-50 mV = index 2, >50 mV = index 3; discharge energy ratio >90% = index 1, 70-90% = index 2, <70% = index 3, etc.).

The method of determining the normal degradation index and the abnormal degradation index described above is summarizd as shown in Table 2 below.

**[Table 2]**

| Classificati on | Details of diagnosis | Base informati on | Index matching | | |
|---|---|---|---|---|---|
| | | | 100 | 80 | 60 |
| Normal degradation | Mileage-based SOH degradation degree | Current SOH and warranty SOH | 100 % | 80 % | 60 % |
| | Variation in internal resistance | Pulse section voltage data | Less than A mΩ | A mΩ or more | B mΩ or more |
| Abnormal degradation | Inter-cell voltagedeviati on | Voltage for each cell | Less than C mV | Less than D mV | Less than E mV |
| | Discharge energy deviation | Discharge energy table and actual amount of discharge | Ratio ranging from 1 to 1.1 | Ratio ranging from 0.95 to 1 | Ratio ranging from 0.8 to 0.95 |
| | Cathode potential change | Cathode potential for each cell | The number of times that a negativ e number is detecte d: 0 | The number of times that a negativ e number is detecte d: 10 or less | The number of times that a negativ e number is detecte d: 50 or less |

In Table 2, A, B, C, D, and E are rational numbers and may satisfy the relationship A<B and the relationship C<D<E. In addition, although index mapping sections are divided in 20-unit intervals within the range of 100 to 60 in Table 2 for simplicity of illustration, it should be understood that, in practice, in determining each index, the index matching sections may be divided into smaller unit intervals within a wider index mapping range (e.g., 5-unit, 10-unit, or dynamic adaptive intervals, etc.). Furthermore, it should be noted that a ratio value assigned to each index matching section in determining the discharge energy deviation, and the number of detections or a reference value assigned to each index matching section in determining the cathode potential change are merely exemplary (e.g., other manufacturers may apply thresholds at 90%, 75%, or 65% SOH, or use different voltage deviation bands, etc.).

In the meantime, the portion exceeding 1 in the ratio matched to an index of 100 for the discharge energy deviation considers a situation in which a spare capacity margin for satisfying a quality index is applied in production and the initial discharge capability exceeds 100 % of the design value (e.g., cells binned with extra usable capacity, conservative design margins in early-life testing, or factory calibration offsets, etc.).

In determining the final normal degradation index or abnormal degradation index, an arithmetic average of the related index values may be applied, or different weights may be applied to the respective index values (e.g., giving higher weight to SOH, equal weight to SOH and resistance variation, or prioritizing inter-cell voltage deviation over cathode potential, etc.). If some index values are not available at the time of determining the degradation index, the degradation index may be determined using only the index values that are available at that time (e.g., if cathode potential data is missing, rely only on SOH and resistance; if discharge energy logs are unavailable, rely on inter-cell deviation, etc.).

If the normal degradation index and the abnormal degradation index are determined through the above-described process, the controller may determine the battery stress level based on these indexes in step S346 (e.g., mapping combined index scores into levels such as healthy, moderate, severe, or critical, etc.).

As described above, the battery stress level may include a plurality of levels, and the respective levels may correspond to different normal degradation indexes and abnormal degradation indexes (e.g., stress level 1 linked to high SOH and low resistance change, stress level 3 linked to moderate SOH decline and voltage deviation, or stress level 5 linked to severe cathode potential drop and high inter-cell imbalance, etc.).

The relationship between the battery stress levels and the degradation indexes may be defined as shown in Table 3 below.

**[Table 3]**

| Battery stress level | Battery state | Degradation index range |
|---|---|---|
| 1 | Healthy | Normal degradation index ranging 70 ~ 100 |
| | | Abnormal degradation index ranging 70 ~ 100 |
| 2 | Start of normal degradation | Normal degradation index ranging 50 ~ 70 |
| | | Abnormal degradation index of 70 or more |
| 3 | Start of abnormal degradation | Abnormal degradation index ranging 50 ~ 70 |
| 4 | Normal degradation and abnormal degradation are mixed | Normal degradation index less than 70 for 5 cycles or more |
| | | Abnormal degradation index less than 50 for 5 cycles or more |
| | | Abnormal degradation index dropped by 5 or more for 3 consecutive cycles |
| 5 | Rapid abnormal degradation | Normal degradation index less than 50 for 5 cycles or more |
| | | Abnormal degradation index less than 50 for 2 consecutive cycles |

The matching relationship between the battery stress levels and the degradation indexes shown in Table 3 is merely an example and is not limited thereto (e.g., other implementations may use 4 levels, 6 levels, or continuous scaling of stress levels, etc.).

Next, with reference to FIG. 8, the relationship between the battery stress levels, the degradation indexes, and the charging modes will be described.

FIG. 8 shows an example of a correlation between a battery degradation index and a charging mode according to an example.

In FIG. 8, it is assumed that battery stress level 1 corresponds to the "healthy" region, battery stress level 2 corresponds to the "normal degradation" region, battery stress level 3 corresponds to the "abnormal degradation" region, and battery stress levels 4 and 5 correspond to the "severe degradation" region (e.g., mapping stress level 1 to new vehicles, stress level 3 to moderate SOH drop, and stress level 5 to cells showing abnormal resistance growth, etc.).

Referring to FIG. 8, four regions are classified according to the combination of the normal degradation index and the abnormal degradation index, and whether charging modes are permitted (or enabled) or not permitted (or disabled) for each region is shown. This permission/non-permission (e.g., enabling or disabling) may be referenced in determination in step S408 described above with reference to FIG. 4 (e.g., restricting fast charging in high-stress conditions, only allowing care mode when abnormal degradation is present, or enabling safety mode as a fallback, etc.).

Specifically, in the healthy region in which both the normal degradation index and the abnormal degradation index are high, charging in the maximum power charging mode may be permitted. In addition, in the normal degradation region in which the normal degradation index is lower than the abnormal degradation index, the degradation mitigation mode and the care mode may be permitted, and a charging parameter of the degradation mitigation mode may be adjusted according to the normal degradation index (e.g., lowering maximum current, reducing SOC target, or extending charging duration, etc.). In addition, in the abnormal degradation region in which the abnormal degradation index is lower than the normal degradation index, the degradation mitigation mode and the care mode are permitted and a charging parameter of the degradation mitigation mode may be adjusted according to the abnormal degradation index (e.g., lowering charging ramp rate, activating thermal cooling, or reducing end-SOC limit, etc.). Only the care mode and the safety mode may be permitted in the severe degradation region (e.g., limiting SOC to 50%, trickle charging only, or warning the driver to seek service, etc.).

The form of region classification and the charging modes permitted/not permitted for each region shown in FIG. 8 are merely illustrative, and are not limited thereto (e.g., some OEMs may define 5 degradation regions, while others may merge them into 3 or define custom charging restrictions, etc.).

Hereinafter, with reference to FIGS. 9 to 12, specific examples will be described in which related information is output to the driver during the charging control process according to an example.

FIG. 9 shows an example of a form in which information on an initial charging mode is output according to an example.

Referring to FIG. 9, charging mode usage status information may be output through a display 161 of the AVNT terminal 160. The charging mode usage status information may include information on the estimated time required for charging for each charging mode based on the current SOC (e.g., 20 minutes in fast mode, 35 minutes in mitigation mode, or 60 minutes in care mode, etc.). Herein, the maximum charging power mode corresponding to the initial charging mode is given a visual effect different from the remaining charging modes, thereby indicating that the maximum charging power mode is the initial charging mode (e.g., highlighting with color, enlarging the button, or adding animation effects, etc.).

FIG. 10 shows an example of a form in which a user selects a charging mode according to an example.

Referring to FIG. 10, as the user's intention of charging is detected (e.g., the charging plug is connected, a "start charging" command is issued, or the driver confirms charging via mobile app, etc.), a menu for selecting any one of the plurality of charging modes may be output through the display 161 of the AVNT terminal 160. Herein, a degradation mitigation mode button 1020 corresponding to the initial charging mode may be given a predetermined visual effect (e.g., color highlighting, flashing outline, or audio cue, etc.). As described above, this menu may correspond to the charging mode selection menu output in step S405B of FIG. 4.

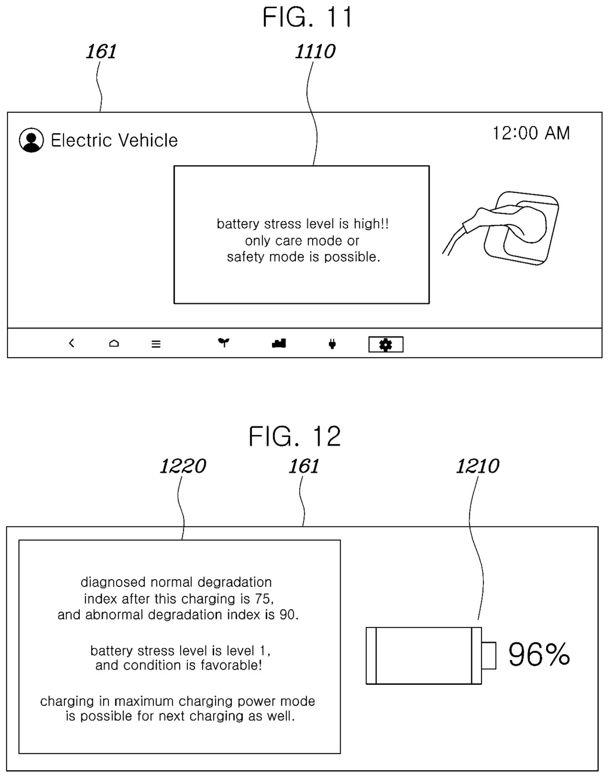

FIG. 11 shows an example of a form in which a message indicating that a charging mode cannot be applied is output according to an example.

FIG. 11 assumes the case in which the driver selects a maximum charging power mode button 1010 in the situation shown in FIG. 10. In this case, as described above with reference to FIG. 8, when the battery degradation index or the battery stress level corresponds to the healthy region, charging in the maximum charging power mode may start. Otherwise, as shown in FIG. 11, a message 1110 indicating that the charging mode cannot be applied may be output through the display 161 of the AVNT terminal 160 (e.g., warning popup, audio chime, vibration alert on the steering wheel, or smartphone push notification, etc.).

FIG. 12 shows an example of a form in which charging result information is output according to an example.

Referring to FIG. 12, charging result information may be output through the display 161 of the AVNT terminal 160 as charging is terminated. The charging result information may include information 1210 on the SOC at the end of charging, information on the battery degradation index and the battery stress level re-determined based on information obtained/measured during or after charging, and information 1220 on the charging mode permitted (e.g., enabled or made available for selection) accordingly (e.g., SOC = 85%, stress level 2, mitigation mode permitted; SOC = 95%, stress level 3, only care mode permitted, etc.).

The output form of the charging result information or the types of information included therein shown in FIG. 12 are merely illustrative and not limited thereto (e.g., output may include charging cost, charging history summary, CO₂ savings, or predictive next-service reminders, etc.).

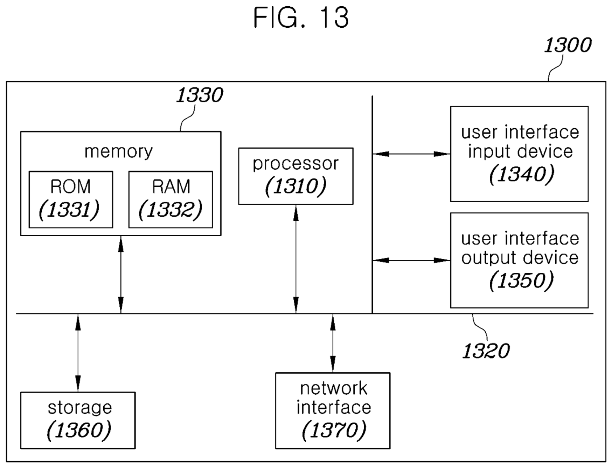

FIG. 13 shows an example computing system (e.g., a computing device of a vehicle or any other apparatus). One or more controllers, processors, etc. described herein, such as one or more components of the vehicle 100 (e.g., BMS), one or more components of the connected car service server, one or more components of the user terminal, and any other components and devices disclosed herein, may be implemented by or in the computing system as shown in FIG. 13.

A computing system 1300 may include at least one processor 1310, memory 1330, a user interface input device 1340, a user interface output device 1350, a storage 1360, and a network interface 1370, which are connected with each other via a bus 1320.

The processor 1310 may be a central processing unit (CPU) or a semiconductor device that processes instructions stored in the memory 1330 and/or the storage 1360. Each of the memory 1330 and the storage 1360 may include various types of volatile or nonvolatile storage media. For example, the memory 1330 may include a read-only memory (ROM) and a random-access memory (RAM).

Communication interface(s) (also referred to as communication device(s), communicator(s), communication module(s), communication unit(s), etc.), such as the network interface 1370, may allow software and/or data to be transferred between a device and one or more external devices, and/or between one or more components of a device. Communication interface(s) may include a receiver, a transmitter, a transceiver, a modem, a network interface and/or adapter (such as an Ethernet adapter), a radio transceiver, an antenna, a communication port, a Personal Computer Memory Card International Association (PCMCIA) slot and card, or the like. Software and data transferred via communication interface(s) may be in the form of signals, which may be electronic, electromagnetic, optical, infrared, or other signals capable of being received by communication interface(s). These signals may be provided to communication interface(s) via a communication path of a device, which may be implemented using, for example, wire or cable, fiber optics, a cellular link, a radio frequency (RF) link and/or other communications channels. Communication interface(s) may communicate using one or more communication protocols, such as Ethernet, Wi-Fi, near-field communication (NFC), Infrared Data Association (IrDA), Bluetooth, Bluetooth low energy (BLE), Zigbee, Long-Term Evolution (LTE), 5G New Radio (NR), vehicle-to-everything (V2X), a controller area network (CAN), or a local interconnect network (LIN), etc.

Accordingly, the operations of the method or algorithm described in connection with example example(s) disclosed in the specification may be directly implemented with a hardware module, a software module, or a combination of the hardware module and the software module, which is executed by the processor 1310. The software module may reside on a storage medium (e.g., the memory 1330 and/or the storage 1360) such as RAM, a flash memory, ROM, an erasable and programmable ROM (EPROM), an electrically EPROM (EEPROM), a register, a hard disk drive, a removable disc, or a compact disc-ROM (CD-ROM).

The storage medium may be coupled to the processor 1100. The processor 1310 may read out information from the storage medium and may write information in the storage medium. Alternatively, the storage medium may be integrated with the processor 1310. The processor and storage medium may be implemented with an application specific integrated circuit (ASIC). The ASIC may be provided in a user terminal. Alternatively, the processor and storage medium may be implemented with separate components in the user terminal.

According to an example, there is provided a charging control device including: a battery; a sensor configured to measure a state of the battery; a memory configured to store usage history data of the battery; and a processor configured to determine an initial charging mode based on the usage history data, determine a degradation indicator for the state of the battery measured by the sensor as a result of accumulated charging, and determine a final charging parameter of the initial charging mode based on the degradation indicator to perform charging control of the battery.

According to an example, the processor may be configured to determine one of a plurality of preset charging modes having different charging operation profiles, as the initial charging mode.

According to an example, the processor may be configured to determine the initial charging mode based on a degradation impact index based on a degree of impact of a plurality of factors included in the history data on degradation of the battery.

According to an example, the degradation impact index may include a degradation high-impact index determined based on at least one factor of which the degree of impact is high among the plurality of factors, and a degradation low-impact index determined based on at least one factor of which the degree of impact is low among the plurality of factors.

According to an example, the processor may be configured to determine the initial charging mode directly when the degradation high-impact index is less than a preset first criterion, or determine the initial charging mode based on the degradation low-impact index when the degradation high-impact index is equal to or greater than the first criterion.

According to an example, the at least one factor of which the degree of impact is high may include at least one selected from a group of the number of rapid charging events, charging power during rapid charging, and a maximum temperature of the battery when charging starts, and the at least one factor of which the degree of impact is low may include at least one selected from a group of the number of slow charging events, whether charging is performed in a preset state-of-charge (SOC) region, and a minimum temperature of the battery when charging starts.

According to an example, the charging control device may further include an information output device, and the processor may be configured to perform control such that information on the initial charging mode is output through the information output device when intention of charging is detected.

According to an example, the processor may be configured to determine whether to permit each of the plurality of charging modes based on a battery stress level according to the degradation indicator.

According to an example, the processor may be configured to determine a normal degradation index and an abnormal degradation index as the degradation indicator for the state of the battery measured by the sensor, and determine the battery stress level based on the determined normal degradation index and the determined abnormal degradation index.

According to an example, the processor may be configured to determine the normal degradation index based on a mileage-based degradation degree (SOH) or an internal resistance variation determined through pulse charging or both.

According to an example, the processor may be configured to determine the abnormal degradation index based on at least one selected from a group of an inter-cell voltage deviation, a discharge energy deviation, and cathode potential change.

According to an example, the battery stress level may be determined to be one of a plurality of preset levels according to the normal degradation index and the abnormal degradation index.

According to an example, the plurality of levels may include at least one selected from a group of a healthy level, a normal degradation level in which the normal degradation index is lower than the abnormal degradation index, an abnormal degradation level in which the abnormal degradation index is lower than the normal degradation index, and a severe degradation level.

According to an example, the processor may be configured to adjust the final charging parameter based on the normal degradation index at the normal degradation level, or adjust the final charging parameter based on the abnormal degradation index at the abnormal degradation level.

According to an example, the processor may be configured to set the amount of charging based on a preset condition in a charging mode corresponding to the severe degradation level among the plurality of charging modes.

According to an example, the mileage-based degradation degree may be determined based on preset reference information.

According to an example, the discharge energy deviation may be determined based on a ratio between a table in which discharge energy according to a state of charge and temperature is pre-defined, and actual discharge energy during driving.

According to an example, the processor may determine, when a user selects a charging mode among the plurality of charging modes rather than the initial charging mode, whether to permit the charging mode selected by the user.

According to an example, the charging control device may further include an information output device, and the processor may be configured to perform control such that when it is determined that the charging mode selected by the user is not permitted, information indicating that the selected charging mode is inapplicable is output through the information output device.

According to an example, the processor may be configured to determine, when it is determined that the charging mode selected by the user is permitted, the charging mode selected by the user as a final charging mode, and adjust a charging parameter of the final charging mode based on the degradation indicator.

According to an example, the processor may be configured to determine, when a preset charging data accumulation condition is not satisfied, the initial charging mode to be a preset mode regardless of the degradation impact index.

In addition, according to an example, there is provided a charging control device including: a battery; a sensor configured to measure a state of the battery; a memory configured to store usage history data of the battery; and a processor configured to control charging of the battery in one charging mode among a plurality of preset charging modes having different charging operation profiles, wherein the processor is configured to determine a normal degradation index and an abnormal degradation index based on usage history data of the battery, and adjust, based on the determined normal degradation index and the determined abnormal degradation index, a charging parameter applied to the one charging mode.

According to an example, the processor may be configured to determine a battery stress level based on the normal degradation index and the abnormal degradation index, and determine whether to permit the one charging mode or adjust the charging parameter based on the determined battery stress level.

In addition, according to an example, there is provided a charging control method including: obtaining usage history information of a battery; outputting information on an initial charging mode determined based on the obtained information among a plurality of charging modes; and performing charging of the battery by adjusting a charging parameter according to a result of a normal degradation diagnosis and a result of an abnormal degradation diagnosis of the battery in the initial charging mode.

According to the above-described various examples, a charging strategy suitable for a charging environment and a battery state can be implemented in an electrified vehicle.

In addition, charging scheduling can be optimized by implementing a suitable charging strategy, and the decline in residual value can be mitigated by extending the lifespan of the battery.

Although the idea or technical scope of the present disclosure has been illustrated and described with reference to particular examples, those skilled in the art will appreciate that various modifications, additions, and substitutions are possible, without departing from the technical idea of the disclosure as disclosed in the accompanying claims.

## Claims

1. An apparatus comprising:
a battery (110);
a sensor configured to measure a state of the battery;
a memory (120, 1330) configured to store usage history data of the battery; and
a processor circuit (120, 1310),
**characterized in that** the processor circuit is configured to:
select, based on the usage history data, an initial charging mode of the battery,
determine, based on accumulated charging of the battery and the measured state of the battery, an indicator indicating a degradation level of the battery,
set, based on the indicator, a charging parameter of the initial charging mode, and
control, based on the charging parameter of the initial charging mode, charging of the battery.

2. The apparatus of claim 1, wherein the processor circuit is configured to:
determine, based on a battery stress level according to the indicator, whether to enable at least one of a plurality of preset charging modes,
select, as the initial charging mode, an enabled one of the plurality of preset charging modes, wherein the plurality of preset charging modes have different charging operation profiles.

3. The apparatus of claim 1 or 2, wherein the processor circuit is configured to select the initial charging mode using a degradation impact index that represents a degree of impact of a plurality of factors, derived from the usage history data, on the degradation level of the battery.

4. The apparatus of claim 3, wherein the degradation impact index comprises:
a degradation high-impact index determined based on at least one first factor having an impact greater than a threshold impact level among the plurality of factors, and
a degradation low-impact index determined based on at least one second factor having an impact less than the threshold impact level among the plurality of factors.

5. The apparatus of claim 4, wherein the processor circuit is configured to select the initial charging mode using:
the degradation high-impact index based on a value of the degradation high-impact index being less than a preset first threshold, or
the degradation low-impact index based on a value of the degradation high-impact index being equal to or greater than the preset first threshold.

6. The apparatus of claim 4 or 5, wherein:
the at least one first factor comprises at least one of:
a number of rapid charging events,
charging power during rapid charging, or
a maximum temperature of the battery when charging starts; and
the at least one second factor comprises at least one of:
a number of slow charging events,
whether charging is performed in a preset state-of-charge (SOC) region of the battery, or
a minimum temperature of the battery when charging starts.

7. The apparatus of any one of the preceding claims, further comprising:
an output interface,
wherein the processor circuit is configured to, based on detection of a predicted charging of the battery, output, via the output interface, information on the initial charging mode.

8. The apparatus of any one of the preceding claims, wherein the processor circuit is configured to:
determine whether the indicator corresponds to a normal degradation index or an abnormal degradation index, and
set the battery stress level based on the determination of whether the indicator corresponds to the normal degradation index or the abnormal degradation index.

9. The apparatus of claim 8, wherein the processor circuit is configured to:
determine that the indicator corresponds to the normal degradation index based on at least one of:
a state of health (SOH) associated with the battery, or
an internal resistance variation determined based on pulse charging of the battery, and
determine that the indicator corresponds to the abnormal degradation index based on at least one of:
an inter-cell voltage deviation of cells of the battery,
a discharge energy deviation of the battery, or
a cathode potential change of the battery.

10. The apparatus of claim 8 or 9, wherein the processor circuit is configured to:
determine, as the battery stress level, one of a plurality of preset levels based on the normal degradation index and the abnormal degradation index, wherein the plurality of preset levels comprises at least one of:
a healthy level in which the normal degradation index and the abnormal degradation index are below respective preset thresholds,
a normal degradation level in which the normal degradation index is lower than the abnormal degradation index,
an abnormal degradation level in which the abnormal degradation index is lower than the normal degradation index, or
a severe degradation level in which the normal degradation index and the abnormal degradation index exceed the respective preset thresholds, and
adjust the charging parameter based on:
the normal degradation index at the normal degradation level, or
the abnormal degradation index at the abnormal degradation level.

11. The apparatus of claim 10, wherein the processor circuit is configured to set an amount of charging based on a preset condition in a charging mode among the plurality of preset charging modes, wherein the charging mode corresponds to the severe degradation level.

12. The apparatus of anyone of claims 9-11, wherein the processor circuit is configured to determine the discharge energy deviation based on a ratio between a reference discharge energy and an actual discharge energy, wherein the reference discharge energy is obtained from a table predefined based on a state of charge of the battery and a temperature of the battery, and wherein the actual discharge energy is measured during driving of a vehicle using the battery.

13. The apparatus of claim 2, or of anyone of claims 3-12 provided that in combination with claim 2, further comprising:
an output interface,
wherein the processor circuit is configured to:
determine, based on a user-selected charging mode among the plurality of preset charging modes different from the initial charging mode, whether to enable the user-selected charging mode, and
based on a determination to disable the user-selected charging mode, output, via the output interface, information indicating that the user-selected charging mode is inapplicable.

14. The apparatus of claim 3, or of anyone of claims 4-13 provided that in combination with claim 3, wherein the processor circuit is configured to, based on a preset charging data accumulation condition for the usage history data not being satisfied, determine the initial charging mode to be a preset mode regardless of the degradation impact index.

15. A method performed by an apparatus for charging control of a battery, the method comprising:
obtaining usage history information of the battery (S211, S310);
based on the obtained usage history information, selecting an initial charging mode among a plurality of charging modes (S212, S320, S330);
based on the obtained usage history information, determining a normal degradation index associated with a first battery aging rate and an abnormal degradation index associated with a second battery aging rate greater than the first battery aging rate (S221, S340);
adjusting, a charging parameter of the initial charging mode based on the determined normal degradation index and the determined abnormal degradation index (S223); and
controlling, based on the adjusted charging parameter, charging of the battery (S350).
